# EUROPEAN PATENT APPLICATION

(11) **EP 4 485 519 A1**
(43) Date of publication of application: **01.01.2025**
(21) Application number: 23213919.6
(22) Date of filing: 04.12.2023
(51) Int. Cl.: H01L 21/8234, H01L 27/02, H01L 27/088, G06F 30/392, H01L 29/775, H01L 27/092, H01L 21/8238

(54) **CELL ROWS WITH MIXED HEIGHTS AND MIXED NANORIBBON WIDTHS**

(30) Priority: 28.06.2023 US 202318215514
(71) Applicant: Intel Corporation, Santa Clara, CA 95054 (US)
(72) Inventor: Yemenicioglu, Sukru, Portland, 97229 (US); Stout, Douglas, Aurora, 80016 (US); Wu, Tai-Hsuan, Portland, 97229 (US); Wang, Xinning, Hillsboro, 97124 (US); Brain, Ruth, Portland, 97221 (US); Chen, Chin-Hsuan, Portland, 97229 (US); Venkataraman, Sivakumar, Hillsboro, 97124 (US); Shi, Quan, Portland, 97229 (US); Vladimirovich, Nikolay, Beaverton, 97006 (US)
(74) Representative: Goddar, Heinz J.

(57) **Abstract**

Techniques are described for designing and forming cells comprising transistor devices for an integrated circuit. An integrated circuit structure includes a plurality of cells arranged in rows where some rows have different cell heights compared to other rows. Additionally, the various rows of cells contain semiconductor nanoribbons having different widths between different rows. For example, any number of first rows of cells can each have a first height (h1) and any number of second rows can each have a second height (h2) that is smaller than the first height. The first rows of cells may include transistors with semiconductor nanoribbons having a first width (w1) and the second rows of cells may include transistors with semiconductor nanoribbons having a second width (w2) smaller than the first width. In some cases, any of the first rows of cells may also include transistors with semiconductor nanoribbons having the second width.

## Description

### FIELD OF THE DISCLOSURE

The present disclosure relates to integrated circuits, and more particularly, to designing and forming cells comprising transistor devices for an integrated circuit.

### BACKGROUND

In designing and forming integrated circuit structures, standard unit cell libraries are developed with a given number of transistors per unit cell. A number of signal tracks may also be used in an interconnect layer about the transistors to make connections to the various transistor elements. As devices and unit cells become smaller, maximizing the available space while reducing parasitic effects becomes difficult. Accordingly, there remain a number of non-trivial challenges with respect to designing layout of various cells of the integrated circuit structure for improved PPA (power, performance, and area) performance.

### BRIEF DESCRIPTION OF THE DRAWINGS

Figure 1A is a cross-section view of an integrated circuit structure that includes rows of cells having different heights and different nanoribbons widths, in accordance with an embodiment of the present disclosure.
Figure 1B is a plan view across multiple cells in an array showing rows of different heights and with nanoribbons of different widths, in accordance with an embodiment of the present disclosure.
Figures 2A - 2I are cross-sectional views that illustrate stages in an example process for forming an integrated circuit having rows of cells with different heights and different nanoribbons widths, in accordance with some embodiments of the present disclosure.
Figure 3 illustrates a cross-section view of another integrated circuit having rows of cells with the same height and with different nanoribbons widths, in accordance with some embodiments of the present disclosure.
Figure 4 illustrates a cross-section view of a chip package containing one or more semiconductor dies, in accordance with some embodiments of the present disclosure.
Figure 5 is a flowchart depicting a method of designing and forming the integrated circuit structure of Figures 1A or 1B, in accordance with an embodiment of the present disclosure.
Figure 6 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are described for designing and forming cells comprising transistor devices for an integrated circuit. In an example, an integrated circuit structure includes a plurality of cells arranged in rows where some rows have different cell heights compared to other rows. Additionally, the various rows of cells may contain semiconductor nanoribbons (or nanowires, or other multi-gate channel structures) having different widths between different rows. For example, any number of first rows of cells can each have a first height and any number of second rows can each have a second height that is at least 3 nm smaller than the first height. The first rows of cells may include transistors with semiconductor nanoribbons having a first width and the second rows of cells may include transistors with semiconductor nanoribbons having a second width at least 5 nm smaller than the first width. In some cases, any of the first rows of cells may also include transistors with semiconductor nanoribbons having the second width. In still other examples, a plurality of cell rows may each have the same cell height, but with different configurations of nanoribbons widths amongst the cell rows. Numerous configurations and variations will be apparent in light of this disclosure.

### General Overview

As previously noted above, there remain a number of non-trivial challenges with respect to formation of various semiconductor structures. When fabricating a large number of cells across a large array, many transistor structures remain the same along a given row of cells, such as the size of the semiconductor nanoribbons. However, while this helps to reduce variance that can lower yield, it also can result in unused portions of certain conductive structures, such as the gate structures, which leads to parasitic capacitance. These parasitic effects can reduce switching times of the transistors and degrade the overall performance.

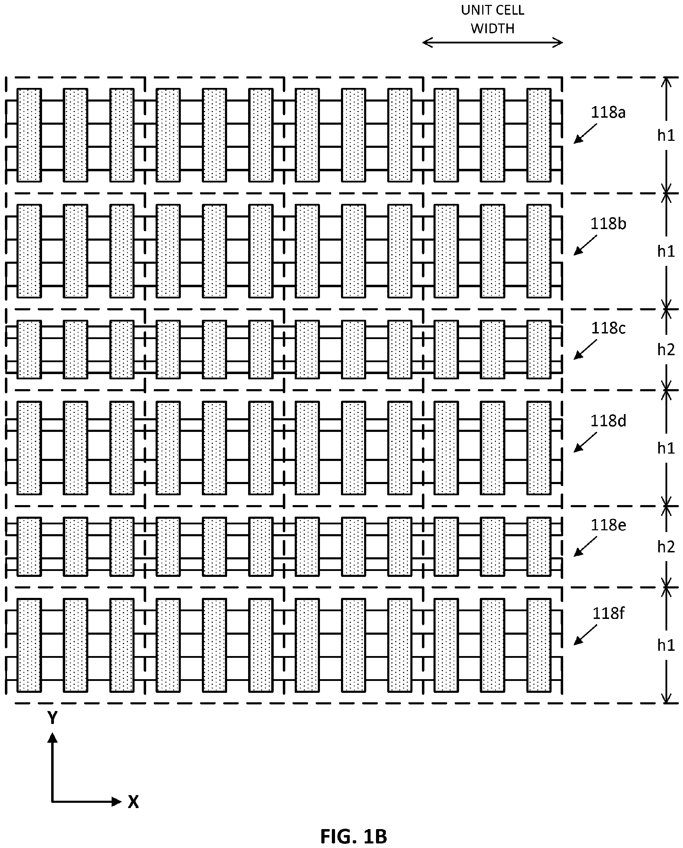

Thus, and in accordance with an embodiment of the present disclosure, techniques are provided herein to form rows of cells having different cell heights to accommodate differently sized nanoribbons while minimizing wasted gate area. Accordingly, one or more rows of first cells may have a first height and one or more rows of second cells may have a second height that is at least 3 nm, at least 5 nm, or at least 7 nm shorter than the first height. There may be some slight variation among the height of the first cells or among the height of the second cells due to process variance. For example, the first cells may each have a height that is within 1 nm of the first height and the second cells may each have a height that is within 1 nm of the second height. Various example heights discussed herein are measured along a Y-axis direction in a plan view orientation (such as shown in Figure 1B). For example, each cell comprises two or more corresponding transistor devices, and the various heights are measured along a length of the gate structures of individual cells. Thus, the height of a cell is not a traditional vertical or Z-axis height - rather, the height of a given cell is a distance between opposing first and second cell boundaries of the given cell (e.g., along the Y-axis direction in the plan view of the structure). It should be understood that the cell boundaries between adjacent cells do not refer to specific structures and instead identify a delineation between repeating transistor arrangements. In some examples, the cell boundaries between adjacent rows of cells pass through gate cuts that extend along the X-direction.

According to some embodiments, the second cells having the second height include one or more semiconductor devices with semiconductor bodies having a shorter width compared to the semiconductor bodies found in semiconductor devices of the first cells having the first height. Semiconductor body widths may be measured along the same direction as the cell heights (e.g., along the Y-axis). The semiconductor bodies may be fins of semiconductor material or may be nanoribbons extending between a source and drain region. The examples described and illustrated herein use nanoribbon semiconductor bodies. In some embodiments, one or more semiconductor bodies within the first cells have a first width and one or more semiconductor bodies within the second cells have a second width that is at least 5 nm, at least 7 nm, at least 10 nm, or at least 15 nm shorter than the first width.

A cell array may include any arrangement of rows of first cells and rows of second cells. In some embodiments, the cell array may include any number of rows of third cells having substantially (e.g., within 1 nm) the same height as the first cells, but a mixed arrangement of semiconductor body widths. For example, the third cells may include a first semiconductor device having a semiconductor body with the first width and a second semiconductor device having a semiconductor body with the second width.

In some embodiments, all rows of a cell array may include substantially the same cell height, but may include differently sized semiconductor bodies. For example, some rows may include semiconductor bodies each with the first width, some rows may include semiconductor bodies each with the second width, and some rows may include one or more semiconductor bodies with the first width and one or more semiconductor bodies with the second width.

According to an embodiment, an integrated circuit structure includes a plurality of first cells and a plurality of second cells. Each of the first cells has a corresponding height along a first direction that is within 1 nanometer (nm) of a first height and includes corresponding two or more transistor devices. Each of the second cells has a corresponding height along the first direction that is within 1 nm of a second height with the second height being at least 3 nm smaller than the first height. Each of the second cells has corresponding two or more transistor devices. The first direction is parallel to a length of a gate structure of a first cell or a second cell. The plurality of first cells are arranged in one or more first rows and the plurality of second cells are arranged in one or more second rows such that the one or more first rows each has the first height and the one or more second rows each has the second height. The corresponding two or more transistor devices of at least one first cell includes a first transistor device having a first semiconductor body with a first width along the first direction and the corresponding two or more transistor devices of at least one second cell includes a second transistor device having a semiconductor body with a second width along the first direction. The second width is shorter than the first width by at least 5 nm.

According to another embodiment, an integrated circuit designing system includes at least one processor and a non-transitory storage medium storing instructions that, when executed by the at least one processor, cause the system to perform a method. The method includes accessing a cell library having first cells and second cells, receiving data about a circuit to be implemented using the first and second cells, and designing one or more first rows that include the first cells and one or more second rows that include the second cells. Each first cell has a first height along a first direction and each second cell has a second height along the first direction with the second height being at least 3 nm smaller than the first height. Each first cell and each second cell includes corresponding two or more transistor devices, and the first direction is parallel to a length of a gate structure of a first cell or a second cell. The one or more first rows each has the first height and the one or more second rows each has the second height. The corresponding two or more transistor devices of at least one first cell includes a first transistor device having a first semiconductor body with a first width along the first direction and the corresponding two or more transistor devices of at least one second cell includes a second transistor device having a semiconductor body with a second width along the first direction that is shorter than the first width by at least 5 nm.

According to another embodiment, an integrated circuit structure includes a plurality of first cells and a plurality of second cells. Each first cell has a corresponding height along a first direction, and each first cell has corresponding two or more transistor devices. Each second cell has substantially the same corresponding height along the first direction, and each second cell has corresponding two or more transistor devices. The first direction is parallel to a length of a gate structure of a first cell or a second cell. The plurality of first cells are arranged in one or more first rows and the plurality of second cells are arranged in one or more second rows. The corresponding two or more transistor devices of at least one first cell includes a first transistor device having a first semiconductor body with a first width along the first direction and the corresponding two or more transistor devices of at least one second cell includes a second transistor device having a semiconductor body with a second width along the first direction that is shorter than the first width by at least 5 nm.

The techniques can be used with any type of non-planar transistors, including finFETs (sometimes called double-gate transistors, or tri-gate transistors), or nanowire and nanoribbon transistors (sometimes called gate-all-around transistors), to name a few examples. The source and drain regions can be, for example, doped portions of a given fin or substrate, or epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process), or any other gate formation process. Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate rows of cells where some rows have a shorter height than other rows. In such examples, the height of a given cell may be measured between gate cuts that extend along the cell boundaries between adjacent rows. Furthermore, transistor devices having different semiconductor body widths may be observed between first cells of a first height and second cells of a second height shorter than the first height. Numerous configurations and variations will be apparent in light of this disclosure.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the material has an element that is not in the other material.

### Architecture

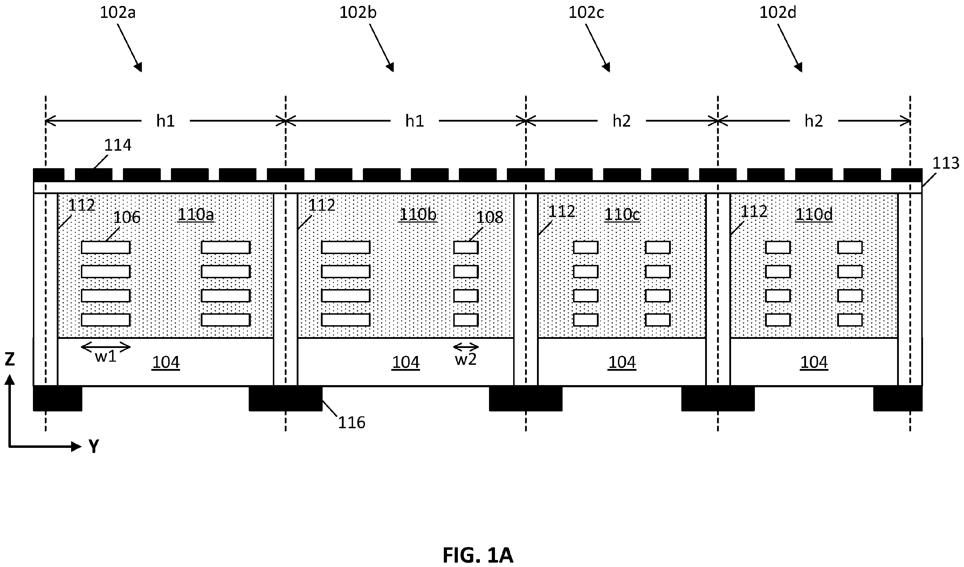

Figure 1A is a cross-section view of a portion of an integrated circuit that includes semiconductor devices arranged within adjacent cells, in accordance with an embodiment of the present disclosure. Each of the semiconductor devices may be non-planar metal oxide semiconductor (MOS) transistors, such as tri-gate or gate-all-around (GAA) transistors, although other transistor topologies and types could also benefit from the techniques provided herein. The examples herein illustrate semiconductor devices with a GAA structure (e.g., having nanoribbons, nanowires, or nanosheets that extend between source and drain regions). Figure 1 illustrates four example cells 102a - 102d adjacent to one another along a first direction (e.g., the Y direction). Each cell may be one cell of a given row of cells extending in a second direction (e.g., the X direction) into and out of the page as shown more clearly in the plan view of Figure 1B. Accordingly, the illustrated cells 102a-102d may be part of the same column of cells.

The one or more semiconductor regions of the devices may include fins that can be, for example, native to a substrate (formed from the substrate itself), such as silicon fins etched from a bulk silicon substrate. Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In still other embodiments, the fins include alternating layers of material (e.g., alternating layers of silicon and SiGe) that facilitates forming of nanowires and nanoribbons during a gate forming process where one type of the alternating layers are selectively etched away so as to liberate the other type of alternating layers within the channel region, so that a gate-all-around process can then be carried out. Again, the alternating layers can be blanket deposited and then etched into fins or deposited into fin-shaped trenches.

According to some embodiments, the semiconductor substrate is removed and replaced with a base dielectric layer 104. The backside removal process may be performed to form backside interconnect structures and/or to remove any semiconductor material from beneath the devices that may form parasitic channels. Base dielectric layer 104 may include any suitable dielectric material, such as silicon dioxide. In some examples, base dielectric layer 104 represents a combination of various dielectric layers that may be formed at different stages of the fabrication process.

Each cell 102a - 102d includes two or more semiconductor devices. Each semiconductor device may include any number of nanoribbons, although four nanoribbons are illustrated herein for each semiconductor device. In some examples, each semiconductor device includes only three nanoribbons. The illustrated view shows two semiconductor devices in each of the cells. Each semiconductor device includes one or more semiconductor regions, such as one or more first nanoribbons 106 or second nanoribbons 108 extending between corresponding epitaxial source or drain regions (not shown in this view) in the second direction along the X-axis. The nanoribbons 106/108 may include any suitable semiconductor material, such as silicon, germanium, or silicon germanium. First nanoribbons 106 may have a greater width (e.g., along the first direction) compared to a width of second nanoribbons 108. In some embodiments, first nanoribbons 106 have a first width w1 between about 18 nm and about 35 nm, and second nanoribbons 108 have a second width w2 between about 6 nm and about 20 nm. In some examples, first width w1 is at least 5 nm, at least 7 nm, at least 10 nm, or at least 15 nm greater than second width w2. It should be understood that the various nanoribbons or semiconductor fin of a given device may taper in width along the third direction (e.g., along the Z-direction) due to fabrication constraints. Accordingly, widths compared between different semiconductor devices are compared along a common XY plane passing through the nanoribbons or semiconductor fins of the devices. In one example, widths between different semiconductor devices having first nanoribbons 106 or second nanoribbons 108 are compared using a topmost or bottommost nanoribbon of each device.

According to some embodiments, some cells have different heights and a different arrangement of transistors with either first nanoribbons 106 or second nanoribbons 108. For example, a first cell 102a and a second cell 102b may each have a first height h1 along the first direction and a third cell 102c and a fourth cell 102d may each have a second height h2 along the first direction. The first height h1 may be greater than the second height h2 by at least 3 nm, at least 5 nm, or at least 7 nm. All cells of a given row (e.g., along the X-direction) may share the same cell height. According to some embodiments, the cells having the shorter height h2, such as third cell 102c and fourth cell 102d, include only semiconductor devices with the second nanoribbons 108 having the smaller second width w2. According to some embodiments, the cells having the larger height h1 may include only semiconductor devices with the first nanoribbons 106 (such as first cell 102a) or may include at least one semiconductor device having the first nanoribbons 106 (such as second cell 102b). Thus, some rows of cells may include only semiconductor devices with the first width w1, some rows of cells may include only semiconductor devices with the second width w2, and some rows of cells may include one or more semiconductor devices with the first width w1 and one or more semiconductor devices with the second width w2. The cells that include only semiconductor devices with the second width w2 can be made to have a lower height, thus eliminating unnecessary portions of the gate structure.

Each of the cells includes a corresponding gate structure 110a - 1 10d that extends lengthwise along the height of each cell (e.g., along the Y-direction). Each gate structure includes a gate electrode and a gate dielectric to form the transistor gate. The gate dielectric may represent any number of dielectric layers. The gate electrode may include any sufficiently conductive material such as a metal, metal alloy, or doped polysilicon. In some embodiments, the gate electrode includes one or more workfunction metals around the one or more semiconductor regions. In some embodiments, p-channel devices include a workfunction metal having titanium around its one or more semiconductor regions and n-channel devices include a workfunction metal having tungsten around its one or more semiconductor regions. The gate electrode may also include a fill metal or other conductive material around the workfunction metals to provide the whole gate electrode structure. A given gate structure may extend over the semiconductor bodies of more than one semiconductor device. In the illustrated example, each gate structure 110a - 110d extends over two corresponding semiconductor bodies to provide two semiconductor devices in each cell.

According to some embodiments, one or more dielectric walls 112 (e.g., gate cuts) extend across the gate structure in the second direction (e.g., along the X-direction). Dielectric walls 112 may continue to extend in the second direction across any number of other gate trenches and source/drain trenches to separate the cell rows from one another. Accordingly, the cell boundaries between rows (identified by the dashed lines) may pass through dielectric walls 112. In this way, the location of dielectric walls 112 along the first direction may determine the locations of the cell boundaries and respectfully the heights of the cells. According to some embodiments, one or more dielectric walls 112 include any suitable dielectric material, such as silicon nitride, silicon oxide, or silicon oxynitride. According to some embodiments, one or more dielectric walls 112 extend at least through an entire thickness of the gate structures 110a - 110d. In some examples, one or more dielectric walls 112 also extend through an entire thickness of base dielectric layer 104 (as illustrated). A dielectric cap 113 may be formed over the cells to provide separation between the transistor structures and any interconnect structures formed over them.

According to some embodiments, a plurality of first conductive layers 114 may be formed over the cells 102a - 102d and extend lengthwise along the second direction (e.g., the X-direction). First conductive layers 114 may be generally formed in parallel strips equally spaced from one another. In some examples, first conductive layers 114 represent a first metal layer of an interconnect structure above the cells. Accordingly, first conductive layers 114 may be used to provide logic signals to any of the various transistor elements of the cells. First conductive layers 114 may include any suitable conductive material, such as copper, tungsten, molybdenum, or ruthenium.

According to some embodiments, cells of different heights have a different number of first conductive layers 114 extending over them. For example, first cell 102a and second cell 102b each have the first height h1 and four first conductive layers 114 arranged over the cell and third cell 102c and fourth cell 102d each have the second height h2 and three first conductive layers 114 arranged over the cell. It should be noted that first conductive layers 114 that run through the cell boundaries may be dummy structures that are not used to provide any signals to the circuit. In some examples, these dummy structures are omitted entirely from the structure. In some embodiments, cells having the first height h1 include more first conductive layers 114 compared to cells having the second height h2.

According to some embodiments, a plurality of second conductive layers 116 may be formed beneath the cells 102a - 102d and extend lengthwise along the second direction (e.g., the X-direction). Second conductive layers 116 may be generally formed in parallel strips equally spaced from one another. In some examples, second conductive layers 116 represent metal layers of a backside interconnect structure below the cells. Accordingly, second conductive layers 116 may be used to provide power or ground signals to any of the various transistor elements of the cells. Second conductive layers 116 may include any suitable conductive material, such as copper, tungsten, molybdenum, or ruthenium. In some embodiments, second conductive layers 116 are aligned with the cell boundaries between adjacent rows of cells. Accordingly, second conductive layers 116 may extend along the second direction in the same location as the cell boundaries between adjacent cell rows.

Figure 1B illustrates a plan view of an array of unit cells having substantially the same cell width, but differing cell heights, according to some embodiments. Each cell row 118a - 118f may include any number of cells extending along the second direction, with each cell of a given row having substantially the same height. In the illustrated example, cells rows 118a, 118b, 118d, and 118f have the first cell height h1 and cell rows 118c and 118e have the second cell height h2. The shorter cells include only semiconductor devices with the narrower semiconductor bodies. The longer cells either include only semiconductor devices with the wider semiconductor bodies or include a mix between semiconductor devices with the wider semiconductor bodies and semiconductor devices with the narrower semiconductor bodies.

### Fabrication Methodology

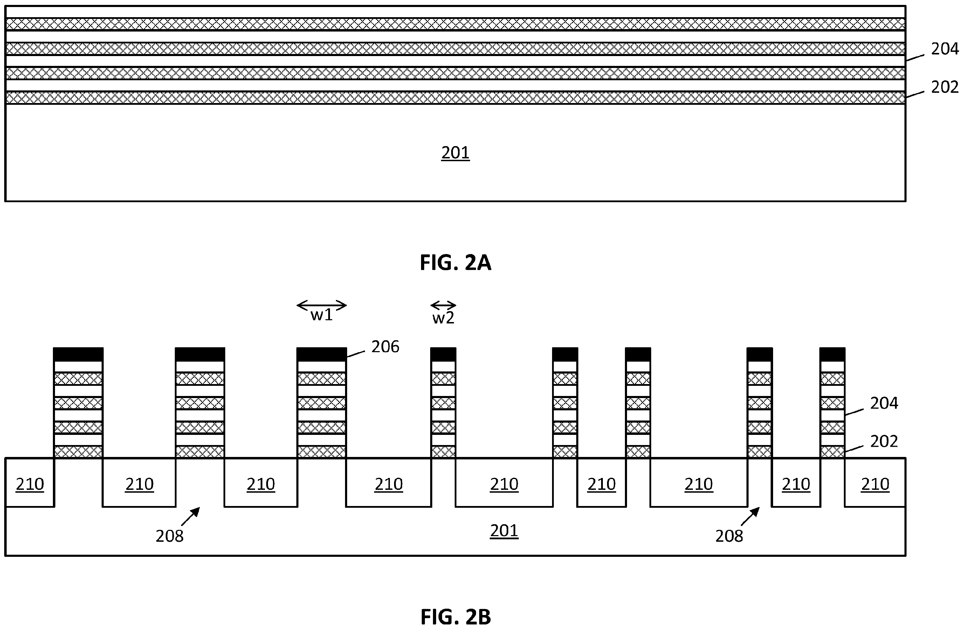

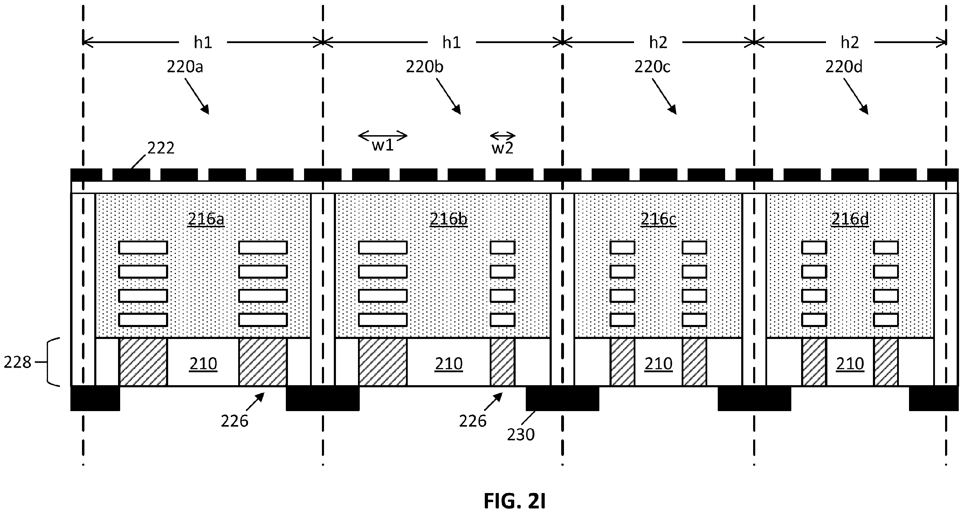

Figures 2A - 2I are cross-sectional views that collectively illustrate an example process for forming an integrated circuit with rows of cells having different heights and different nanoribbons widths, in accordance with an embodiment of the present disclosure. The figures represent cross-sectional views taken along the YZ plane of a given gate trench that crosses multiple cells of a given column of cells. Each figure shows an example structure that results from the process flow up to that point in time, so the depicted structure evolves as the process flow continues, culminating in the structure shown in Figure 21, which is similar to the structure shown in Figure 1A. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but the present disclosure is not intended to be limited to any specific such materials or parameters, as will be appreciated.

Figure 2A illustrates a cross-sectional view of multiple material layers formed over a substrate, according to an embodiment of the present disclosure. Alternating material layers may be deposited over a substrate 201 including sacrificial layers 202 alternating with semiconductor layers 204. The alternating layers are used to form GAA transistor structures. Any number of alternating semiconductor layers 204 and sacrificial layers 202 may be deposited over substrate 201.

Substrate 201 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 201 can be a semiconductor-on-insulator substrate having a desired semiconductor layer over a buried insulator layer (e.g., silicon over silicon dioxide). Alternatively, substrate 201 can be a multilayer substrate or superlattice suitable for forming nanowires or nanoribbons (e.g., alternating layers of silicon and SiGe, or alternating layers indium gallium arsenide and indium phosphide). Any number of substrates can be used.

According to some embodiments, sacrificial layers 202 have a different material composition than semiconductor layers 204. In some embodiments, sacrificial layers 202 are silicon germanium (SiGe) while semiconductor layers 204 include a semiconductor material suitable for use as a nanoribbon such as silicon (Si), SiGe, germanium, or III-V materials like indium phosphide (InP) or gallium arsenide (GaAs). In examples where SiGe is used in each of sacrificial layers 202 and in semiconductor layers 204, the germanium concentration is different between sacrificial layers 202 and semiconductor layers 204. For example, sacrificial layers 202 may include a higher germanium content compared to semiconductor layers 204.

While dimensions can vary from one example embodiment to the next, the thickness of each sacrificial layer 202 may be between about 5 nm and about 20 nm. In some embodiments, the thickness of each sacrificial layer 202 is substantially the same (e.g., within 1-2 nm). The thickness of each of semiconductor layers 204 may be about the same as the thickness of each sacrificial layer 202 (e.g., about 5-20 nm). Each of sacrificial layers 202 and semiconductor layers 204 may be deposited using any known material deposition technique, such as chemical vapor deposition (CVD), plasma-enhanced chemical vapor deposition (PECVD), physical vapor deposition (PVD), or atomic layer deposition (ALD).

Figure 2B depicts the cross-section view of the structure shown in Figure 2A, following the formation of a cap layer 206 and the subsequent formation of fins beneath cap layer 206, according to an embodiment. Cap layer 206 may be any suitable hard mask material such as a carbon hard mask (CHM) or silicon nitride. Cap layer 206 is patterned into rows to form corresponding rows of fins from the alternating layer stack of sacrificial layers 202 and semiconductor layers 204. The rows of fins extend lengthwise in the second direction (e.g., into and out of the page of each cross-section view). Note that some fins are patterned to have a first width w1 while other fins are patterned to have a second width w2 that is smaller than the first width w1. Any number of fins with the first width w1 and fins with the second width w2 may be formed. The distances between adjacent fins may not be consistent depending on where the cell boundaries are.

According to some embodiments, an anisotropic etching process through the layer stack continues into at least a portion of substrate 201, where the unetched portions of substrate 201 beneath the fins form subfin regions 208. The etched portions of substrate 201 may be filled with a dielectric fill 210 that acts as shallow trench isolation (STI) between adjacent fins. Dielectric fill 210 may be any suitable dielectric material such as silicon dioxide, and may be recessed to a desired depth as shown (in this example case, down to around the upper surface of subfin regions 208), so as to define the active portion of the fins that will be covered by a gate structure. In some embodiments, dielectric fill 210 is recessed below the top surface of subfin regions 208.

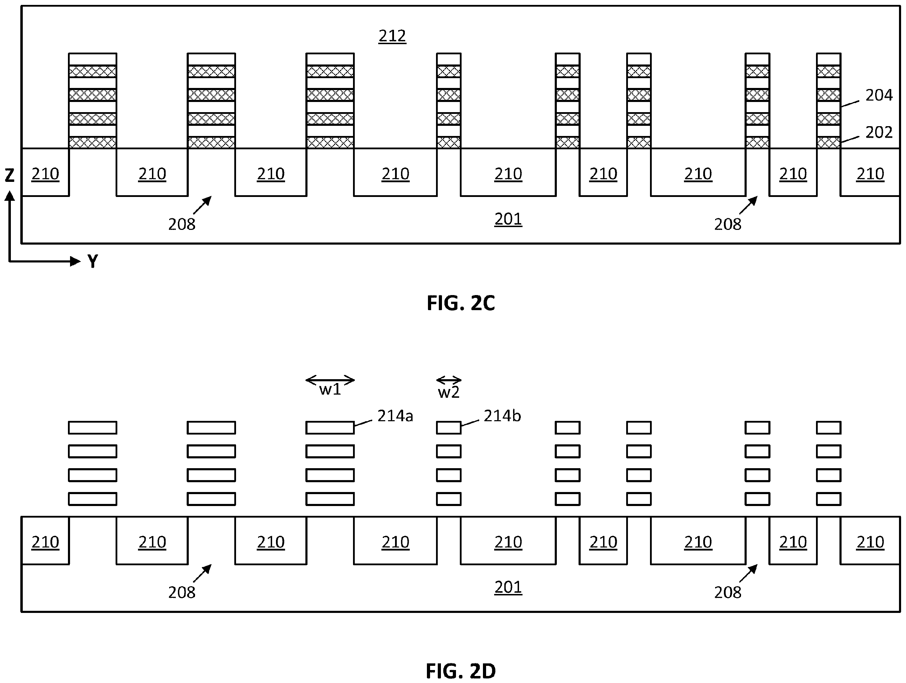

Figure 2C depicts the cross-section view of the structure shown in Figure 2B, following the formation of a sacrificial gate 212 extending across the fins in the first direction, according to some embodiments. As discussed above, the first direction (e.g., along the Y-direction) may be orthogonal to the second direction (e.g., along the X-direction). According to some embodiments, the sacrificial gate material is formed in parallel strips across the integrated circuit and removed in all areas not protected by a gate masking layer. Sacrificial gate 212 may be any suitable material that can be selectively removed without damaging the semiconductor material of the fins. In some examples, sacrificial gate 212 includes polysilicon.

Sacrificial gate 212 (along with any gate spacers formed on the sidewalls of sacrificial gate 212) protect the underlying portions of the fins while the exposed portions of the fins between the gate spacers are etched away. According to some embodiments, both semiconductor layers 204 and sacrificial layers 202 are etched at substantially the same rate using an anisotropic RIE process to form source/drain trenches. In some embodiments, inner gate spacers can be formed after the source/drain trenches are etched and before any formation of source or drain regions. For instance, a selective etch can be used to laterally recess sacrificial layers 202, and that recess can then be filled with inner gate spacer material (e.g., silicon nitride or silicon oxynitride). Any excess gate spacer material can be removed with directional etching.

According to some embodiments, source or drain regions are formed after the formation of sacrificial gate 212. The source or drain regions are not shown in this cross-section as they would exist at the ends of the semiconductor layers 204 into and out of the page. The source or drain regions may be epitaxially grown from the exposed ends of semiconductor layers 204, such that the material grows together or otherwise merges towards the middle of the trenches between fins, according to some embodiments. Note that epitaxial growth on one semiconductor layer 204 can fully or partially merge with epitaxial growth on one or more other semiconductor layers 204 in the same vertical stack. The degree of any such merging can vary from one embodiment to the next. In the example of a PMOS device, a given source or drain region may be a semiconductor material (e.g., group IV or group III-V semiconductor materials) having a higher dopant concentration of p-type dopants compared to n-type dopants. In the example of an NMOS device, a given source or drain region may be a semiconductor material (e.g., group IV or group III-V semiconductor materials) having a higher dopant concentration of n-type dopants compared to p-type dopants. According to some embodiments, the source or drain regions grown from different semiconductor devices may be aligned along the source/drain trench in the second direction.

Figure 2D depicts the cross-section view of the structure shown in Figure 2C following the formation of first nanoribbons 214a and second nanoribbons 214b from semiconductor layers 204, according to some embodiments. Depending on the dimensions of the structures, nanoribbons 214a/214b may also be considered nanowires or nanosheets. Sacrificial gate 212 may be removed using any wet or dry isotropic process thus exposing the alternating layer stack of the fins within the trenches left behind after the removal of sacrificial gate 212. Once sacrificial gate 212 is removed, sacrificial layers 202 may also be removed using a selective isotropic etching process that removes the material of sacrificial layers 202 but does not remove (or removes very little of) semiconductor layers 204 or any other exposed layers (e.g., inner gate spacers). At this point, the suspended (sometimes called released) semiconductor layers 204 form nanoribbons 214a/214b that extend in the first direction (into and out of the page) between corresponding source or drain regions. First nanoribbons 214a may have a first width w1 between about 18 nm and about 35 nm, and second nanoribbons 214b have a second width w2 between about 6 nm and about 20 nm. In some examples, first width w1 is at least 5 nm, at least 7 nm, at least 10 nm, or at least 15 nm greater than second width w2.

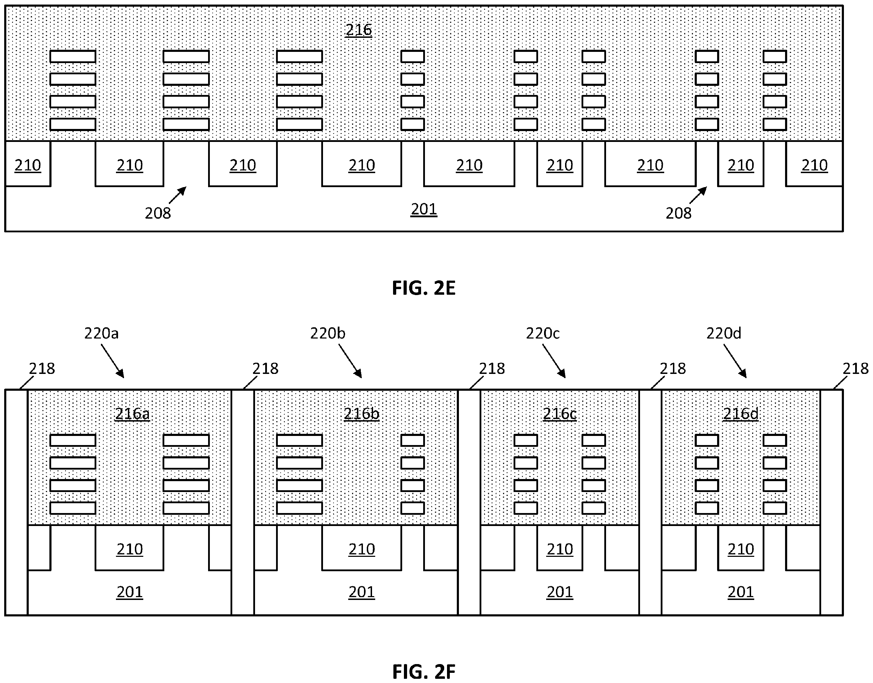

Figure 2E depicts the cross-section view of the structure shown in Figure 2D following the formation of a gate structure around nanoribbons 214a/214b within the gate trench, according to some embodiments. As noted above, the gate structure includes both a gate dielectric and a gate electrode. The gate dielectric may be conformally deposited around nanoribbons 214a/214b using any suitable deposition process, such as atomic layer deposition (ALD) and may include any suitable dielectric (such as silicon dioxide, and/or a high-k dielectric material).

The gate electrode may be deposited over the gate dielectric and can be any conductive structure. In some embodiments, the gate electrode includes doped polysilicon, a metal, or a metal alloy. Example suitable metals or metal alloys include aluminum, tungsten, cobalt, molybdenum, ruthenium, titanium, tantalum, copper, and carbides and nitrides thereof. The gate electrode may include, for instance, one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates.

Figure 2F depicts the cross-section view of the structure shown in Figure 2E following the formation of dielectric walls 218 extending in the second direction between adjacent cells 220a - 220d, according to some embodiments. Dielectric walls 218 may separate gate structure 216 into smaller gate structures within each cell (e.g., a first gate structure 216a of a first cell 220a, a second gate structure 216b of a second cell 220b, a third gate structure 216c of a third cell 220c, and a fourth gate structure 216d of a fourth cell 220d.) Dielectric walls 218 extend to a depth at least through an entire thickness of the gate structures 216a - 216d to isolate separate gate structures along the second direction. In some embodiments, dielectric walls 218 extend into at least a portion of dielectric fill 210 or through an entire thickness of dielectric fill 210. In some embodiments, dielectric walls 218 extend entirely through dielectric fill 210 and into a portion of substrate 201. Dielectric walls 218 may include any suitable dielectric material, such as silicon oxide, silicon nitride, or silicon carbide. In some examples, dielectric walls 218 include a first dielectric layer deposited first and a second dielectric layer or dielectric fill formed on the first dielectric layer. The first dielectric layer may include a high-k dielectric material (e.g., materials with a dielectric constant higher than that of silicon oxide or higher than 3.9) while the second dielectric layer or dielectric fill may include a low-k dielectric material (e.g. materials with a dielectric constant equal to or lower than that of silicon oxide, such as porous silicon oxide, or equal to or lower than 3.9). In some embodiments, the locations of dielectric walls 218 along the first direction define the cell boundaries between adjacent rows of cells and may determine the cell heights along the first direction.

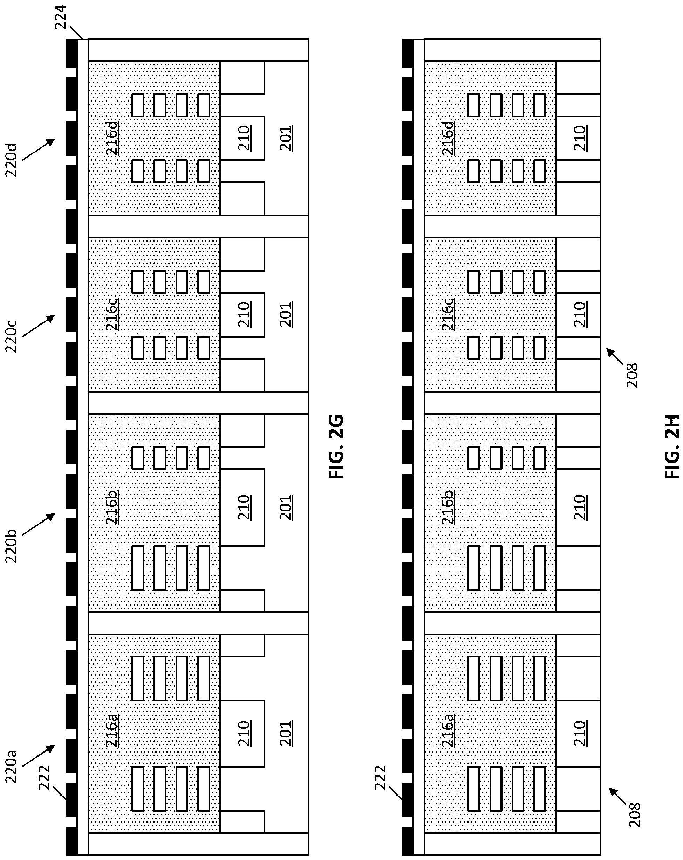

Figure 2G depicts the cross-section view of the structure shown in Figure 2F following the formation of topside interconnect structures, such as first metal layers 222, according to some embodiments. First metal layers 222 may be formed over a dielectric cap layer 224 to isolate first metal layers 222 from the underlying transistor structures. Dielectric cap layer 224 may represent any number of various dielectric materials or layers.

First conductive layers 222 may be generally formed in parallel strips equally spaced from one another. In some examples, first conductive layers 222 represent a first metal layer of an interconnect structure above the cells. Accordingly, first conductive layers 222 may be used to provide logic signals to any of the various transistor elements of the cells (e.g., using vias or contacts to connect with lower transistor structures). First conductive layers 222 may include any suitable conductive material, such as copper, tungsten, molybdenum, or ruthenium.

Figure 2H depicts the cross-section view of the structure shown in Figure 2G following the removal of substrate 201. Any topside interconnect structures (e.g., back-end-of-the-line structures) may be formed prior to the removal of substrate 201. Substrate 201 may be polished away via CMP or another grinding process to remove the substrate material. According to some embodiments, substrate 201 continues to be thinned away at least until dielectric fill 210 and/or subfins 208 are exposed.

Figure 21 depicts the cross-section view of the structure shown in Figure 2H following the formation of a base dielectric layer 228 and backside conductive structures on or below the base dielectric layer, according to some embodiments. Subfins 208 may be removed from the backside and replaced with dielectric plugs 226 to form base dielectric layer 228 that can include both dielectric fill 210 and dielectric plugs 226.

According to some embodiments, second conductive layers 230 are formed on the backside of the structure beneath base dielectric layer 228. Second conductive layers 230 may be generally formed in parallel strips equally spaced from one another. In some examples, second conductive layers 230 may be used to provide power or ground signals to any of the various transistor elements of the cells. Second conductive layers 230 may include any suitable conductive material, such as copper, tungsten, molybdenum, or ruthenium. In some embodiments, second conductive layers 230 are aligned with the cell boundaries between adjacent rows of cells (identified by the dashed lines).

As discussed above, different rows of cells may be distinguished from one another by having different heights along the first direction, different numbers of first conductive layers 222 over the cells, and/or semiconductor devices having semiconductor bodies with different widths. In the illustrated example, a first cell 220a may have substantially the same first height h1 as a second cell 220b, where each of the first cell and second cell includes at least one semiconductor device with nanoribbons of the first width w1. A third cell 220c may have substantially the same second height h2 as a fourth cell 220d where the second height is smaller than the first height. Additionally, the third cell 220c and fourth cell 220d each include only semiconductor devices with nanoribbons that have the second width w2. Cells having the first height h1 (e.g., first cell 220a and second cell 220b) may have more first conductive layers 222 extending over them in the second direction compared to cells having the second height h2 (e.g., third cell 220c and fourth cell 220d). In the illustrated example, cells having the first height h1 include four first metal layers 222 and cells having the second height h2 include three first metal layers 222. Any arrangement of rows can be used having different heights and/or semiconductor bodies with different widths.

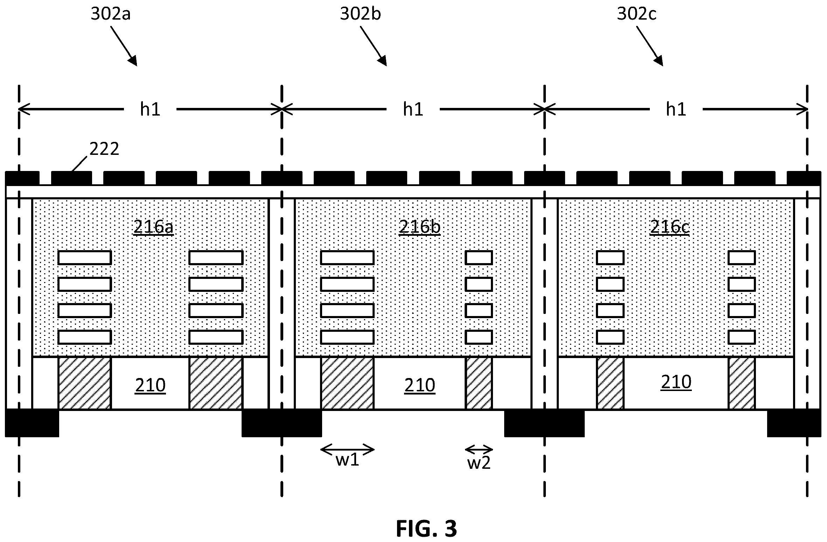

Figure 3 illustrates a cross-section view of another structure having adjacent cells 302a - 302c with substantially the same height, but differently-sized semiconductor devices, according to some embodiments. In the illustrated example, each cell 302a - 302c may be one cell of a corresponding row of cells extending in the second direction, with each cell having substantially the same cell height h1.

According to some embodiments, each row of cells may include any combination of semiconductor devices having semiconductor bodies with the first width w1 and semiconductor devices having semiconductor bodies with the second width w2. In the illustrated example, a first cell 302a includes only semiconductor devices having the first width w1, a second cell 302b includes one or more semiconductor devices having the first width w1 and one or more semiconductor devices having the second width w2, and a third cell 302c includes only semiconductor devices having the second width w2.

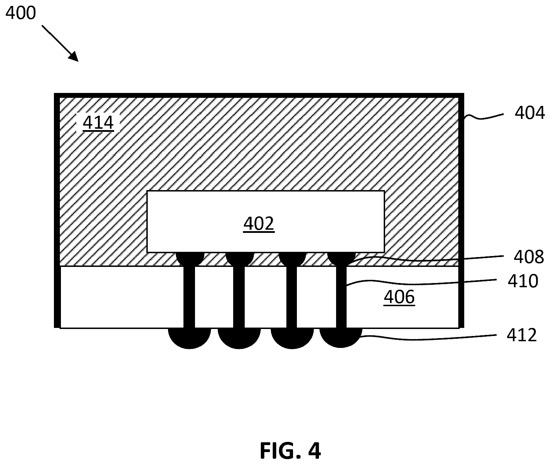

Figure 4 illustrates an example embodiment of a chip package 400, in accordance with an embodiment of the present disclosure. As can be seen, chip package 400 includes one or more dies 402. One or more dies 402 may include at least one integrated circuit having semiconductor devices, such as any of the semiconductor devices disclosed herein. One or more dies 402 may include any other circuitry used to interface with other devices formed on the dies, or other devices connected to chip package 400, in some example configurations.

As can be further seen, chip package 400 includes a housing 404 that is bonded to a package substrate 406. The housing 404 may be any standard or proprietary housing, and may provide, for example, electromagnetic shielding and environmental protection for the components of chip package 400. The one or more dies 402 may be conductively coupled to a package substrate 406 using connections 408, which may be implemented with any number of standard or proprietary connection mechanisms, such as solder bumps, ball grid array (BGA), pins, or wire bonds, to name a few examples. Package substrate 406 may be any standard or proprietary package substrate, but in some cases includes a dielectric material having conductive pathways (e.g., including conductive vias and lines) extending through the dielectric material between the faces of package substrate 406, or between different locations on each face. In some embodiments, package substrate 406 may have a thickness less than 1 millimeter (e.g., between 0.1 millimeters and 0.5 millimeters), although any number of package geometries can be used. Additional conductive contacts 412 may be disposed at an opposite face of package substrate 406 for conductively contacting, for instance, a printed circuit board (PCB). One or more vias 410 extend through a thickness of package substrate 406 to provide conductive pathways between one or more of connections 408 to one or more of contacts 412. Vias 410 are illustrated as single straight columns through package substrate 406 for ease of illustration, although other configurations can be used (e.g., damascene, dual damascene, through-silicon via, or an interconnect structure that meanders through the thickness of substrate 406 to contact one or more intermediate locations therein). In still other embodiments, vias 410 are fabricated by multiple smaller stacked vias, or are staggered at different locations across package substrate 406. In the illustrated embodiment, contacts 412 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 412, to inhibit shorting.

In some embodiments, a mold material 414 may be disposed around the one or more dies 402 included within housing 404 (e.g., between dies 402 and package substrate 406 as an underfill material, as well as between dies 402 and housing 404 as an overfill material). Although the dimensions and qualities of the mold material 414 can vary from one embodiment to the next, in some embodiments, a thickness of mold material 414 is less than 1 millimeter. Example materials that may be used for mold material 414 include epoxy mold materials, as suitable. In some cases, the mold material 414 is thermally conductive, in addition to being electrically insulating.

### Methodology

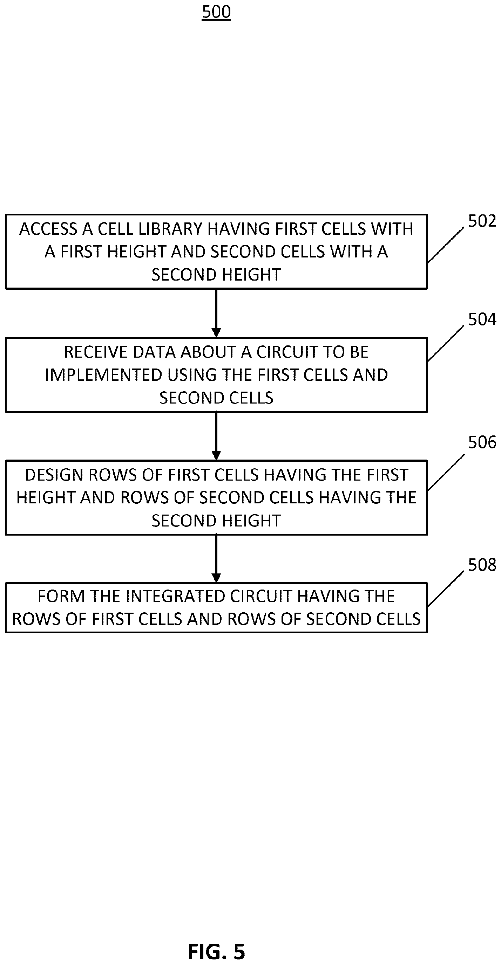

Figure 5 illustrates a flowchart depicting a method 500 of designing and forming the integrated circuit structure of Figure 1A or 1B, in accordance with some embodiments of the present disclosure.

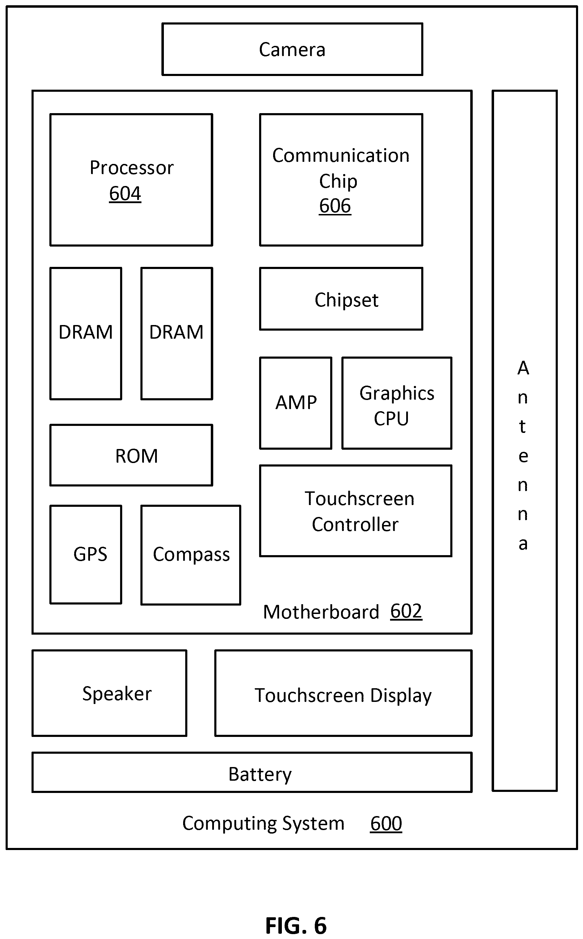

In an example, a hardware computer may be used to implement one or more operations of method 500, such as operations 502, 504, and/or 506. The hardware computer may include a hardware processor communicatively coupled to a non-transitory, computer readable storage medium that includes a set of executable instructions, when executed, can perform one or more design operations of method 500. The hardware processor may execute the instructions within the computer readable storage medium, to perform the operations 502, 504, and/or 506 of method 500. In an example, the hardware processor is a central processing unit (CPU), a graphic processing unit (GPU), a distributed processing system, an application specific integrated circuit (ASIC), and/or another appropriate processor. In an example, the computer readable storage medium is an appropriate storage medium, such as a volatile memory (e.g., DRAM), non-volatile memory (e.g., ROM), a mass storage device (such as hard disk drive, compact disk (CD), digital versatile disk (DVD), and so forth). Examples of the hardware processor and the computer readable storage medium have been discussed herein with respect to Figure 6.

Method 500 includes operation 502 where a cell library is accessed that has first cells with a first height and second cells with a second height different from the first height. An appropriate integrated circuit design tool, such as an EDA (Electronic design automation) tool being executed in the hardware computer, may be used for forming and/or accessing the cell library and for subsequent design processes. In some examples, each of the first and second cells includes the same number of transistors (e.g., two, four, or six transistors each). The second height of the second cells may be at least 3 nm, at least 5 nm, or at least 7 nm smaller than the first height of the first cells. In some embodiments, the transistor devices of the first cells include one or more transistors having a first width and the transistor devices of the second cells include one or more transistors having a second width smaller than the first width.

Method 500 continues with operation 504 where data about a circuit to be implemented using the cells is received (e.g., by the hardware computer).

Method 500 continues with operation 506 where an integrated circuit structure having an array of cells is designed. The cells may be arranged in an array of adjacent rows and columns. Any given row may include only first cells or only second cells, and the rows may be arranged in any order with each other. It should be understood that the array may also include space between any two adjacent cells.

According to some embodiments, one or more first rows may include first cells having the first height and only semiconductor devices with the first width. As noted above, the width of the semiconductor devices may be measured as the width of the semiconductor bodies of the devices along the same direction as the heights of the cells. According to some embodiments, one or more second rows may include first cells having the first height and one or more semiconductor devices with the first width and one or more semiconductor devices with the second width. The first cells of the one or more second rows may include an equal number of semiconductor devices with the first width and semiconductor devices with the second width. According to some embodiments, one or more third rows may include second cells having the second height and only semiconductor devices with the second width.

The method 500 then proceeds to operation 508 where the integrated circuit having the array of unit cells and interconnect structures is formed. According to some embodiments, the integrated circuit may be formed using any of the techniques described with reference to Figures 2A - 2I.

Note that the operations in method 500 are shown in a particular order for ease of description. However, one or more of the processes may be performed in a different order or may not be performed at all (and thus be optional), in accordance with some embodiments. Numerous variations on method 500 and the techniques described herein will be apparent in light of this disclosure.

### Example System

Figure 6 illustrates a computing system 600 implemented with any number of integrated circuit structures (such as the integrated circuit structure illustrated in Figure 1A or 1B) discussed herein and/or used to implement the design processes discussed with respect to the method 500 of Figure 5, in accordance with some embodiments of the present disclosure. As can be seen, the computing system 600 houses a motherboard 602. The motherboard 602 may include a number of components, including, but not limited to, a processor 604 and at least one communication chip 606, each of which can be physically and electrically coupled to the motherboard 602, or otherwise integrated therein. As will be appreciated, the motherboard 602 may be, for example, any printed circuit board, whether a main board, a daughterboard mounted on a main board, or the only board of system 600, etc.

Depending on its applications, computing system 600 may include one or more other components that may or may not be physically and electrically coupled to the motherboard 602. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 600 may include one or more integrated circuit structures or devices formed using the disclosed techniques in accordance with an example embodiment. In some embodiments, multiple functions can be integrated into one or more chips (e.g., for instance, note that the communication chip 606 can be part of or otherwise integrated into the processor 604).

The communication chip 606 enables wireless communications for the transfer of data to and from the computing system 600. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 606 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 600 may include a plurality of communication chips 606. For instance, a first communication chip 606 may be dedicated to shorter range wireless communications such as Wi-Fi and Bluetooth and a second communication chip 606 may be dedicated to longer range wireless communications such as GPS, EDGE, GPRS, CDMA, WiMAX, LTE, Ev-DO, and others.

The processor 604 of the computing system 600 includes an integrated circuit die packaged within the processor 604. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 606 also may include an integrated circuit die packaged within the communication chip 606. In accordance with some such example embodiments, the integrated circuit die of the communication chip includes one or more semiconductor devices as variously described herein. As will be appreciated in light of this disclosure, note that multi-standard wireless capability may be integrated directly into the processor 604 (e.g., where functionality of any chips 606 is integrated into processor 604, rather than having separate communication chips). Further note that processor 604 may be a chip set having such wireless capability. In short, any number of processor 604 and/or communication chips 606 can be used. Likewise, any one chip or chip set can have multiple functions integrated therein.

In various implementations, the computing system 600 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 600 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit structure that includes a plurality of first cells and a plurality of second cells. Each of the first cells has a corresponding height along a first direction that is within 1 nanometer (nm) of a first height and includes corresponding two or more transistor devices. Each of the second cells has a corresponding height along the first direction that is within 1 nm of a second height with the second height being at least 3 nm smaller than the first height. Each of the second cells has corresponding two or more transistor devices. The first direction is parallel to a length of a gate structure of a first cell or a second cell. The plurality of first cells are arranged in one or more first rows and the plurality of second cells are arranged in one or more second rows such that the one or more first rows each has the first height and the one or more second rows each has the second height. The corresponding two or more transistor devices of at least one first cell includes a first transistor device having a first semiconductor body with a first width along the first direction and the corresponding two or more transistor devices of at least one second cell includes a second transistor device having a semiconductor body with a second width along the first direction. The second width is shorter than the first width by at least 5 nm.

Example 2 includes the integrated circuit structure of Example 1, wherein the first semiconductor body comprises one or more first semiconductor nanoribbons and the second semiconductor body comprises one or more second semiconductor nanoribbons.

Example 3 includes the integrated circuit structure of Example 2, wherein the one or more first semiconductor nanoribbons and the one or more second semiconductor nanoribbons comprise germanium, silicon, or any combination thereof.

Example 4 includes the integrated circuit structure of any one of Examples 1-3, further comprising a gate cut extending lengthwise along a second direction different from the first direction and along a boundary between adjacent rows of first cells and/or second cells.

Example 5 includes the integrated circuit structure of Example 4, wherein the first direction is orthogonal to the second direction.

Example 6 includes the integrated circuit structure of any one of Examples 1-5, wherein a third transistor device of the two or more transistor devices of the at least one first cell has a third semiconductor body with the second width.

Example 7 includes the integrated circuit structure of any one of Examples 1-6, wherein each of the two or more transistor devices of the at least one first cell has a corresponding semiconductor body with substantially the same first width, and each of the two or more transistor devices of the at least one second cell has a corresponding semiconductor body with substantially the same second width.

Example 8 includes the integrated circuit structure of any one of Examples 1-7, further comprising a first plurality of conductive layers extending lengthwise along a second direction different from the first direction and over a given first cell of the plurality of first cells, and a second plurality of conductive layers extending lengthwise along the second direction and over a given second cell of the plurality of second cells. The first plurality of conductive layers includes more conductive layers than the second plurality of conductive layers.

Example 9 includes the integrated circuit structure of Example 8, wherein the first plurality of conductive layers consists of four conductive layers and the second plurality of conductive layers consists of three conductive layers.

Example 10 includes the integrated circuit structure of any one of Examples 1-9, wherein the second width along the first direction is shorter than the first width by at least 10 nm.

Example 11 is a printed circuit board comprising the integrated circuit structure of any one of Examples 1-10.

Example 12 is an integrated circuit designing system that includes at least one processor and a non-transitory storage medium storing instructions that, when executed by the at least one processor, cause the system to perform a method. The method includes accessing a cell library having first cells and second cells, receiving data about a circuit to be implemented using the first and second cells, and designing one or more first rows that include the first cells and one or more second rows that include the second cells. Each first cell has a first height along a first direction and each second cell has a second height along the first direction with the second height being at least 3 nm smaller than the first height. Each first cell and each second cell includes corresponding two or more transistor devices, and the first direction is parallel to a length of a gate structure of a first cell or a second cell. The one or more first rows each has the first height and the one or more second rows each has the second height. The corresponding two or more transistor devices of at least one first cell includes a first transistor device having a first semiconductor body with a first width along the first direction and the corresponding two or more transistor devices of at least one second cell includes a second transistor device having a semiconductor body with a second width along the first direction that is shorter than the first width by at least 5 nm.

Example 13 includes the integrated circuit designing system of Example 12, wherein the designing comprises designing a gate cut extending lengthwise along a second direction different from the first direction and along a boundary between adjacent rows of first cells and/or second cells.

Example 14 includes the integrated circuit designing system of Example 13, wherein the first direction is orthogonal to the second direction.

Example 15 includes the integrated circuit designing system of any one of Examples 12-14, wherein a third transistor device of the two or more transistor devices of the at least one first cell has a third semiconductor body with the second width.

Example 16 includes the integrated circuit designing system of any one of Examples 12-15, wherein each of the two or more transistor devices of the at least one first cell has a corresponding semiconductor body with substantially the same first width, and each of the two or more transistor devices of the at least one second cell has a corresponding semiconductor body with substantially the same second width.

Example 17 includes the integrated circuit designing system of any one of Examples 12-16, wherein the method further comprises designing a first plurality of conductive layers over a given first cell of the first cells, and designing a second plurality of conductive layers over a given second cell of the second cells. The first plurality of conductive layers extend lengthwise along a second direction different from the first direction, and the second plurality of conductive layers extend lengthwise along the second direction.

Example 18 includes the integrated circuit designing system of Example 17, wherein the first plurality of conductive layers consists of four conductive layers and the second plurality of conductive layers consists of three conductive layers.

Example 19 includes the integrated circuit designing system of any one of Examples 12-18, wherein the second width along the first direction is shorter than the first width by at least 10 nm.

Example 20 is an integrated circuit structure that includes a plurality of first cells and a plurality of second cells. Each first cell has a corresponding height along a first direction, and each first cell has corresponding two or more transistor devices. Each second cell has substantially the same corresponding height along the first direction, and each second cell has corresponding two or more transistor devices. The first direction is parallel to a length of a gate structure of a first cell or a second cell. The plurality of first cells are arranged in one or more first rows and the plurality of second cells are arranged in one or more second rows. The corresponding two or more transistor devices of at least one first cell includes a first transistor device having a first semiconductor body with a first width along the first direction and the corresponding two or more transistor devices of at least one second cell includes a second transistor device having a semiconductor body with a second width along the first direction that is shorter than the first width by at least 5 nm.

Example 21 includes the integrated circuit structure of Example 20, wherein the first semiconductor body comprises one or more first semiconductor nanoribbons and the second semiconductor body comprises one or more second semiconductor nanoribbons.

Example 22 includes the integrated circuit structure of Example 21, wherein the one or more first semiconductor nanoribbons and the one or more second semiconductor nanoribbons comprise germanium, silicon, or any combination thereof.

Example 23 includes the integrated circuit structure of any one of Examples 20-22, further comprising a gate cut extending lengthwise along a second direction different from the first direction and along a boundary between adjacent rows of first cells and/or second cells.

Example 24 includes the integrated circuit structure of Example 23, wherein the first direction is orthogonal to the second direction.

Example 25 includes the integrated circuit structure of any one of Examples 20-24, wherein a third transistor device of the two or more transistor devices of the at least one first cell has a third semiconductor body with the second width.

Example 26 includes the integrated circuit structure of any one of Examples 20-24, wherein each of the two or more transistor devices of the at least one first cell has a corresponding semiconductor body with substantially the same first width, and each of the two or more transistor devices of the at least one second cell has a corresponding semiconductor body with substantially the same second width.

Example 27 includes the integrated circuit structure of Example 26, further comprising a plurality of third cells with each third cell having substantially the same corresponding height along the first direction. Each third cell has corresponding two or more transistor devices, and the plurality of third cells are arranged in one or more third rows. At least one of the two or more transistor devices of at least one third cell has a corresponding semiconductor body with substantially the same first width and at least one of the two or more transistor devices of the at least one third cell has a corresponding semiconductor body with substantially the same second width.

Example 28 includes the integrated circuit structure of any one of Examples 20-27, wherein the second width along the first direction is shorter than the first width by at least 10 nm.

Example 29 is a printed circuit board comprising the integrated circuit structure of any one of Examples 20-28.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit structure, comprising:
a plurality of first cells, each first cell having a corresponding height along a first direction that is within 1 nanometer (nm) of a first height, wherein each first cell has corresponding two or more transistor devices; and
a plurality of second cells, each second cell having a corresponding height along the first direction that is within 1 nm of a second height, the second height at least 3 nm smaller than the first height, wherein each second cell has corresponding two or more transistor devices;
wherein the first direction is parallel to a length of a gate structure of a first cell or a second cell;
wherein the plurality of first cells are arranged in one or more first rows and the plurality of second cells are arranged in one or more second rows such that the one or more first rows each has the first height and the one or more second rows each has the second height; and
wherein the corresponding two or more transistor devices of at least one first cell includes a first transistor device having a first semiconductor body with a first width along the first direction and the corresponding two or more transistor devices of at least one second cell includes a second transistor device having a semiconductor body with a second width along the first direction that is shorter than the first width by at least 5 nm.

2. The integrated circuit structure of claim 1, wherein the first semiconductor body comprises one or more first semiconductor nanoribbons and the second semiconductor body comprises one or more second semiconductor nanoribbons.

3. The integrated circuit structure of claim 2, wherein the one or more first semiconductor nanoribbons and the one or more second semiconductor nanoribbons comprise germanium, silicon, or any combination thereof.

4. The integrated circuit structure of any one of claims 1 through 3, further comprising a gate cut extending lengthwise along a second direction different from the first direction and along a boundary between adjacent rows of first cells and/or second cells.

5. The integrated circuit structure of claim 4, wherein the first direction is orthogonal to the second direction.

6. The integrated circuit structure of any one of claims 1 through 5, wherein a third transistor device of the two or more transistor devices of the at least one first cell has a third semiconductor body with the second width.

7. The integrated circuit structure of any one of claims 1 through 6, wherein each of the two or more transistor devices of the at least one first cell has a corresponding semiconductor body with substantially the same first width, and each of the two or more transistor devices of the at least one second cell has a corresponding semiconductor body with substantially the same second width.

8. The integrated circuit structure of any one of claims 1 through 7, further comprising:
a first plurality of conductive layers extending lengthwise along a second direction different from the first direction and over a given first cell of the plurality of first cells; and
a second plurality of conductive layers extending lengthwise along the second direction and over a given second cell of the plurality of second cells, wherein the first plurality of conductive layers includes more conductive layers than the second plurality of conductive layers.

9. The integrated circuit structure of claim 8, wherein the first plurality of conductive layers consists of four conductive layers and the second plurality of conductive layers consists of three conductive layers.

10. The integrated circuit structure of any one of claims 1 through 9, wherein the second width along the first direction is shorter than the first width by at least 10 nm.

11. A printed circuit board comprising the integrated circuit structure of any one of claims 1 through 10.

12. An integrated circuit designing system comprising:
at least one processor; and
a non-transitory storage medium storing instructions that, when executed by the at least one processor, cause the system to perform a method comprising
accessing a cell library having first cells and second cells, wherein each first cell has a first height along a first direction and each second cell has a second height along the first direction, the second height at least 3 nm smaller than the first height, wherein each first cell and each second cell comprises corresponding two or more transistor devices, and wherein the first direction is parallel to a length of a gate structure of a first cell or a second cell,
receiving data about a circuit to be implemented using the first and second cells, and
designing one or more first rows that include the first cells and one or more second rows that include the second cells such that the one or more first rows each has the first height and the one or more second rows each has the second height, wherein the corresponding two or more transistor devices of at least one first cell includes a first transistor device having a first semiconductor body with a first width along the first direction and the corresponding two or more transistor devices of at least one second cell includes a second transistor device having a semiconductor body with a second width along the first direction that is shorter than the first width by at least 5 nm.

13. The integrated circuit designing system of claim 12, wherein the designing comprises designing a gate cut extending lengthwise along a second direction different from the first direction and along a boundary between adjacent rows of first cells and/or second cells.

14. The integrated circuit designing system of claim 12 or 13, wherein each of the two or more transistor devices of the at least one first cell has a corresponding semiconductor body with substantially the same first width, and each of the two or more transistor devices of the at least one second cell has a corresponding semiconductor body with substantially the same second width.

15. The integrated circuit designing system of any one of claims 12 through 14,
wherein the method further comprises:
designing a first plurality of conductive layers over a given first cell of the first cells, the first plurality of conductive layers extending lengthwise along a second direction different from the first direction; and
designing a second plurality of conductive layers over a given second cell of the second cells, the second plurality of conductive layers extending lengthwise along the second direction.
